# EUROPEAN PATENT APPLICATION

(11) **EP 2 413 358 A1**
(43) Date of publication of application: **01.02.2012**
(21) Application number: 10171106.7
(22) Date of filing: 28.07.2010
(51) Int. Cl.: H01L 25/075, H01L 33/62, H01L 33/64, H01L 33/50

(54) **LED lamp with multiple color temperatures**

(71) Applicant: Civilight Qidong Lighting Technology Co., Ltd., Binhai Industrial Park Qidong Jiangsu (CN)
(72) Inventor: Xue, Xinshen, Shenzhen Guangdong (CN)
(74) Representative: MERH-IP Matias Erny Reichl Hoffmann

(57) **Abstract**

An LED lamp with multiple color temperatures includes an LED lamp having a white light chip, a yellow light chip, and a red light chip and an LED substrate for supporting the LED lamp thereon. Each positive electrode of the white light chip, the yellow light chip, and the red light chip is fixedly coupled to a common area of the LED substrate to form a common positive electrode, and each negative electrodes of the white light chip, the yellow light chip, and the red light chip is respectively coupled to the LED substrate to form the negative electrode of the white light chip, the negative electrode of the yellow light chip, and the negative electrode of the red light chip. The LED lamp with multiple color temperatures may achieve three segments available color temperatures without replacing any LED. According to the different requirement of users, the users can separately choose the three light chips to be lightened in order to obtain different color temperatures.

## Description

### TECHNICAL FIELD

The present invention relates to a lamp, and more particularly, to an LED lamp with multiple color temperatures.

### BACKGROUND

Regarding to the conventional lamps, the lamps with a regulatory function mainly include table lamps, bedside lamps, and so on. These lamps generally use an incandescent bulb as a light source. These lamps can only adjust the brightness of light, and can not adjust the color of light. Incandescent lamps as a light source, have low luminous efficiency, high power consumption, and short service life, and are easy to generate an amount of heat.

As a new light source, LED lamps have small volume, low power consumption, long service life, high luminous efficiency. In addition, LED lamps are non-toxic, environmentally friendly, durable, rich colors and so on.

Among the current LED lamps, the single LED can only implement a single color temperature which can not be adjusted. The lighting effect of LED lamps with low color temperature is warm color, and the lighting effect of LED lamps with high color temperature is cool color. When the external environment is changed, the lighting and environment discord each other to influence the lighting and decorative effect.

The brightness of LED lamps can be changed by using the latest pulse width modulation technology, but a little change will be produced in color temperature, and the change of color temperature does not exceed 100K. Accordingly, in a conventional technology, LED lamps can not achieve greater range of color temperature adjustment by the circuit regulation.

### SUMMARY

The technical problem which is needed to be solved by the present patent application is to provide an LED lamp with multiple color temperatures, thereby overcoming the above-mentioned shortcomings.

A technical scheme for solving the technical problem of the present patent application is described as follows: An LED lamp with multiple color temperatures includes an LED lamp having a white light chip, a yellow light chip, and a red light chip and an LED substrate for supporting the LED lamp thereon. Each positive electrode of the white light chip, the yellow light chip, and the red light chip is fixedly coupled to a common area of the LED substrate to form a common positive electrode, and each negative electrode of the white light chip, the yellow light chip, and the red light chip is respectively coupled to the LED substrate to form the negative electrode of the white light chip, the negative electrode of the yellow light chip, and the negative electrode of the red light chip.

Preferably, the LED substrate defines a heat conducting channel therein, and/or the white light chip, the yellow light chip and/or the red light chip are fixed to the heat conducting channel of the LED substrate.

Preferably, the white light chip is lightened to thereby obtain color temperature from 5000K to 7000K.

Preferably, the white light chip and yellow light chip are simultaneously lightened to thereby obtain color temperature from 3500K to 5000K.

Preferably, the white light chip, yellow light chip, and red light chip are simultaneously lightened to thereby obtain color temperature from 2700K to 3500K.

Compared with the prior art, the LED lamp with multiple color temperatures has the following advantages: Firstly, the LED lamp with multiple color temperatures can achieve three segments available color temperatures without replacing any LED. According to the different requirement of users, the users can separately choose the white light chip, the yellow light chip, and the red light chip to be lightened, or the three chips are simultaneously lightened in order to obtain different color temperatures. When the external environment is changed, the lighting and environment are matched each other to create different visual effects and good decorative effect. Secondly, the LED lamp with multiple color temperatures has achieved the range of color temperature from 2700K-7000K by packaging technology, and broken the bottleneck of the conventional technology. Finally, the LED lamp with multiple color temperatures has simple structure, low cost, non-toxic, and environment friendly.

### BRIEF DESCRIPTION OF THE DRAWINGS

Other objects, advantages and novel features of the present invention will become more apparent from the following detailed description when taken in conjunction with the accompanying drawings, in which:

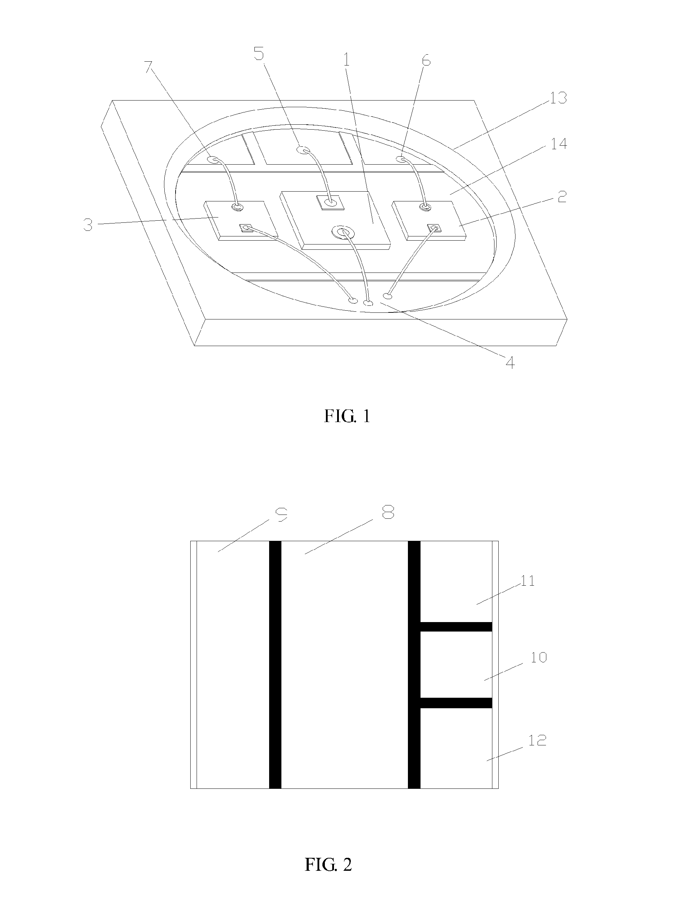

FIG. 1 is a structural view of an LED lamp with multiple color temperatures in the accordance with an embodiment in the present invention; and

FIG. 2 is a structural view of a rear side of the LED lamp with multiple color temperatures in the accordance with the embodiment in the present invention. Reference numerals : 1-white light chip; 2-yellow light chip; 3-red light chip; 4-common positive electrode; 5-negative electrode of the white light chip; 6- negative electrode of the yellow light chip; 7- negative electrode of the red light chip; 8- heat conducting channel; 9-welding area of the common positive electrode; 10- welding area of the negative electrode of the white light chip; 11- welding area of the negative electrode of the yellow light chip; 12- welding area of the negative electrode of the red light chip; 13-LED lamp; 14-LED substrate.

### DETAILED DESCRIPTION OF THE PREFERRED EMBODIMENTS

Objects, advantages and embodiments of the present invention will be explained below in detail with reference to the accompanying drawings. However, it is to be appreciated that the following description of the embodiment(s) is merely exemplary in nature and is no way intended to limit the invention, its application, or uses.

Referring to the FIG.1, in the embodiment, the LED lamp with multiple color temperatures includes an LED lamp 13 and an LED substrate 14 for supporting the LED lamp 13 thereon. The LED lamp 13 includes a white light chip 1, a yellow light chip 2, and a red light chip 3. The positive electrodes of the white light chip 1, the yellow light chip 2, and the red light chip 3 are fixedly coupled to a common area of the LED substrate 14 to form a common positive electrode 4. The negative electrodes of the white light chip 1, the yellow light chip 2, and the red light chip 3 are respectively and securely coupled to the LED substrate 14 to form a negative electrode 5 of the white light chip 1, a negative electrode 6 of the yellow light chip 2, and a negative electrode 7 of the red light chip 3.

The LED substrate 14 defines a heat conducting channel 8 therein. The white light chip 1, the yellow light chip 2, and the red light chip 3 are fixed to the heat conducting channel 8 of the LED substrate 14. Thus, the heat generated by the three chips is easily dissipated to thereby not influence performance of the LED lamp.

The common positive electrode 4 and negative electrode 5 of the white light chip 1 are switched on, and then the white light chip 1 is lightened to obtain color temperature from 5000K to 7000K.

The common positive electrode 4 and negative electrode 5 of the white light chip 1, and the common positive electrode 4 and negative electrode 6 of the yellow light chip 2 are switched on, and then the white light chip 1 and yellow light chip 2 are simultaneously lightened to obtain color temperature from 3500K to 5000K.

The common positive electrode 4 and negative electrode 5 of the white light chip 1, the common positive electrode 4 and negative electrode 6 of the yellow light chip 2, and the common positive electrode 4 and negative electrode 7 of the red light chip 3 are switched on, and then the white light chip 1, yellow light chip 2, and red light chip 3 are simultaneously lightened to obtain color temperature from 2700K to 3500K.

According to the different requirement of users, the users can separately choose the white light chip 1, the yellow light chip 2, and the red light chip 3 to be lightened, or the three chips are simultaneously lightened in order to obtain different color temperatures.

Referring to the FIG.2, a rear side of the LED lamp with multiple color temperatures in the accordance with the embodiment in the present invention includes a welding area 9 of the common positive electrode 4, a welding area 10 of the negative electrode of the white light chip 1, a welding area 11 of the negative electrode of the yellow light chip 2, and a welding area 12 of the negative electrode of the red light chip 3. The heat conducting channel 8 is defined in a central portion of a rear side of the LED substrate 14.

The present invention may be embodied in other forms without departing from the spirit or novel characteristics thereof. The embodiments disclosed in this application are to be considered in all respects as illustrative and not limitative. The scope of the invention is indicated by the appended claims rather than by the foregoing description; and all changes which come within the meaning and range of equivalency of the claims are intended to be embraced therein.

## Claims

1. An LED lamp with multiple color temperatures comprising:
an LED lamp (13) having a white light chip (1), a yellow light chip (2), and a red light chip (3); and
an LED substrate (14) for supporting the LED lamp (13) thereon; wherein each positive electrode of the white light chip (1), the yellow light chip (2), and the red light chip (3) is fixedly coupled to a common area of the LED substrate (14) to form a common positive electrode (4), each negative electrode of the white light chip (1), the yellow light chip (2), and the red light chip (3) is respectively coupled to the LED substrate (14) to form the negative electrode (5) of the white light chip (1), the negative electrode (6) of the yellow light chip (2), and the negative electrode (7) of the red light chip (3).

2. The LED lamp as claimed in claim 1, wherein the LED substrate defines a heat conducting channel therein, and the white light chip, the yellow light chip and the red light chip are fixed to the heat conducting channel of the LED substrate.

3. The LED lamp as claimed in claim 1 or 2, wherein the white light chip is lightened to thereby obtain color temperature from 5000K to 7000K.

4. The LED lamp as claimed in at least one of claims 1 - 3, wherein the white light chip and yellow light chip are simultaneously lightened to thereby obtain color temperature from 3500K to 5000K.

5. The LED lamp as claimed in at least one of claims 1 - 4, wherein the white light chip, yellow light chip, and red light chip are simultaneously lightened to thereby obtain color temperature from 2700K to 3500K.
